# EUROPEAN PATENT SPECIFICATION

(11) **EP 4 520 657 B1**
(45) Date of publication and mention of the grant of the patent: **28.10.2026**
(21) Application number: 24199041.5
(22) Date of filing: 06.09.2024
(51) Int. Cl.: B64C 3/44, H10N 10/13, H10N 10/17

(54) **AIRCRAFT AIRFOIL FORMED FROM THERMALLY ADAPTIVE MATERIALS AND INCLUDING DAMPING ELEMENT, STIFFENING ELEMENT, AND A THERMOELECTRIC JUNCTION**
AUS WÄRMEADAPTIVEN MATERIALIEN GEFORMTE FLUGZEUGTRAGFLÄCHE MIT DÄMPFUNGSELEMENT, VERSTEIFUNGSELEMENT UND THERMOELEKTRISCHER VERBINDUNG
PROFIL AÉRODYNAMIQUE D'AÉRONEF FORMÉ DE MATÉRIAUX THERMIQUEMENT ADAPTATIFS ET COMPRENANT UN ÉLÉMENT D'AMORTISSEMENT, UN ÉLÉMENT DE RAIDISSEMENT ET UNE JONCTION THERMOÉLECTRIQUE

(30) Priority: 08.09.2023 US 202318464165; 08.12.2023 US 202318533952
(43) Date of publication of application: 12.03.2025
(73) Proprietor: Hamilton Sundstrand Corporation, Charlotte, NC 28217-4578 (US)
(72) Inventor: KILCHYK, Viktor, Lancaster, 14086 (US); MERRITT, Brent J., Southwick, 01077 (US)
(74) Representative: Dehns

(56) References cited:
- EP-A1- 2 974 954
- EP-A1- 4 177 440
- US-A- 5 230 850

## Description

### BACKGROUND

The embodiments are directed to an airfoil of an aircraft and more specifically to an airfoil, of an aircraft, that is formed from thermally adaptive materials and including damping element, stiffening element, and a thermoelectric junction.

Memory shape alloys may be utilized for various applications to avoid the requirement of utilizing complex machinery. However, working fluid temperatures may undesirably control the shape of the alloy. Components made of thermally adaptive material are disclosed in EP 4 177 440 A1 and EP 2 974 954 A1.

### BRIEF DESCRIPTION

Disclosed is an airfoil, including a body defining a leading edge and a trailing edge, wherein the body comprises: a base having an outer boundary extending longitudinally from a first end to a second end and transversely from a first side to a second side; and beads within the outer boundary, wherein each of the beads has a bead void, and wherein one or more of the beads includes: a damping element within the bead void; and a stiffening element extending across the bead over the void.

In embodiments, the damping element is a thermoplastic.

In embodiments, the stiffening element is a reinforcement fiber.

In embodiments, the stiffening element one of: a metal fiber; a carbon fiber; and a fiberglass fiber.

In embodiments, each of the beads is nonmetal.

In embodiments, each of the beads defines: first and second perimeter segments that are opposite each other and have a first CTE; and third and fourth perimeter segments that are opposite each other and adjacent to the first and second perimeter segments and have a second CTE that differs from the first CTE, to define a bead CTE gradient.

In embodiments, a thermoelectric junction is disposed around the outer boundary or in one or more of the bead voids.

In embodiments, one or more of the beads includes each of: the thermoelectric junction; the damping element within the bead void; and the stiffening element extending across the bead.

In embodiments, each of the beads defines: an outer surface; and an inner surface, wherein the inner surface defines the bead void, wherein: the outer surface of the first and second perimeter segments has the first CTE, and the inner surface of the first and second perimeter segments has the second CTE; and the outer surface of the third and fourth perimeter segments has the second CTE, and the inner surface of the third and fourth perimeter segments has the first CTE.

In embodiments, the outer boundary defines a first outer end and a second outer end, wherein the first and second outer ends are opposite each other, and the base includes a top elastomer layer that is disposed against the first outer end of the outer boundary and a bottom elastomer layer that is disposed against the second outer end of the outer boundary.

In embodiments, the base includes an elastomer segment that extends from each of the beads that are located along the outer boundary of the base, so that adjacent ones of the elastomer segments overlap each other to define a flexible outer boundary cover.

In embodiments, the base is formed as a block having base voids, wherein each of the base voids is lined with one of the beads.

In embodiments, the block is nonmetal.

In embodiments, each of the beads is oval shaped or diamond shaped.

### BRIEF DESCRIPTION OF THE DRAWINGS

The following descriptions should not be considered limiting in any way. With reference to the accompanying drawings, like elements are numbered alike:
FIG. 1A shows an aircraft according to an embodiment;
FIG. 1B shows a component of the aircraft according to an embodiment, where the component is an airfoil with a first camber profile;
FIG. 1C shows the same airfoil of FIG. 1B with a second camber profile;
FIG. 2 shows a material configuration of the component, having a base formed of a lattice of beads having coefficient of thermal expansion (CTE) gradients selected to provide a predetermined deformation, and where the lattice is formed with one or more of a damping element, a stiffening element and a thermoelectric junction;
FIG. 3A shows the lattice of beads in a normal state;
FIG. 3B shows the lattice of beads in a deformed state;
FIG. 4A shows one of the beads formed with damping element;
FIG. 4B shows the bead of FIG. 4A in a deformed state;
FIG. 5A shows one of the beads formed with stiffening element;
FIG. 5B shows the bead of FIG. 5A in a deformed state;
FIG. 6 shows the lattice of beads with top and bottom elastomer layers;
FIG. 7 shows a plurality of the beads from the lattice, with an elastomer segment extending from each bead, over an adjacent bead, to form a continuous elastomer boundary;
FIG. 8A shows an alternate configuration of the material configuration of the component, having a block shaped base that defines voids, where ones of the voids are lined with one of the beads, and one or more of: damping element formed in one or more of the beads; stiffing material formed across one or more of the beads; and a thermoelectric junction formed either within at least one of the beads or around the base;
FIG. 8B shows the block of FIG. 8A in a deformed state;
FIG. 9A shows an oval shaped bead that may be utilized in the disclosed embodiments;
FIG. 9B shows the bead of FIG. 9A in a deformed state;
FIG. 10A shows a diamond shaped bead that may be utilized in the disclosed embodiments;
FIG. 10B shows the bead of FIG. 10A in a deformed state;
FIG. 11A shows a random shaped bead that may be utilized in the disclosed embodiments;
FIG. 11B shows the bead of FIG. 11 A in a deformed state;
FIG. 12A shows an equivalent structure the structures shown above and for example in FIGS. 2-4; and
FIG. 12B shows the structure of FIG. 12A at a temperature T2>T1 and in a deformed state.

### DETAILED DESCRIPTION

A detailed description of one or more embodiments of the disclosed apparatus and method are presented herein by way of exemplification and not limitation with reference to the Figures.

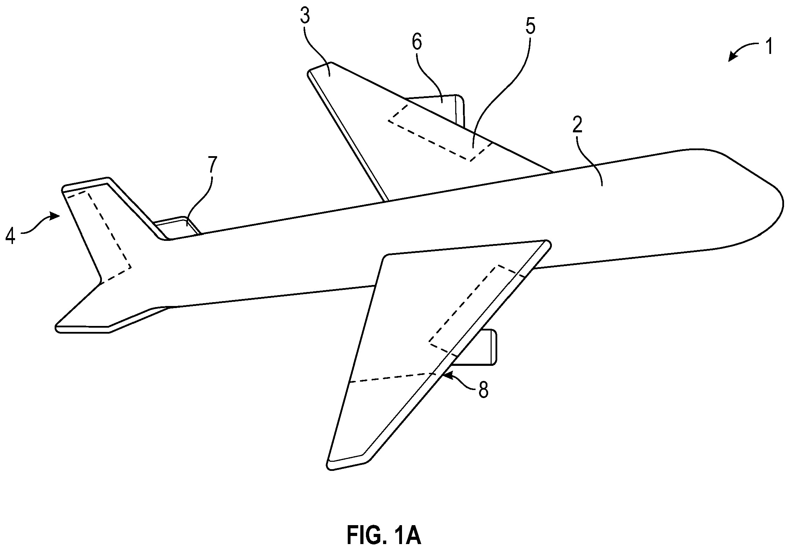

FIG. 1A shows an aircraft 1 having a fuselage 2 with a wing 3 and tail assembly 4, which may have control surfaces 5. The wing 3 may include an engine 6, such as a gas turbine engine, and an auxiliary power unit 7 may be disposed at the tail assembly 4.

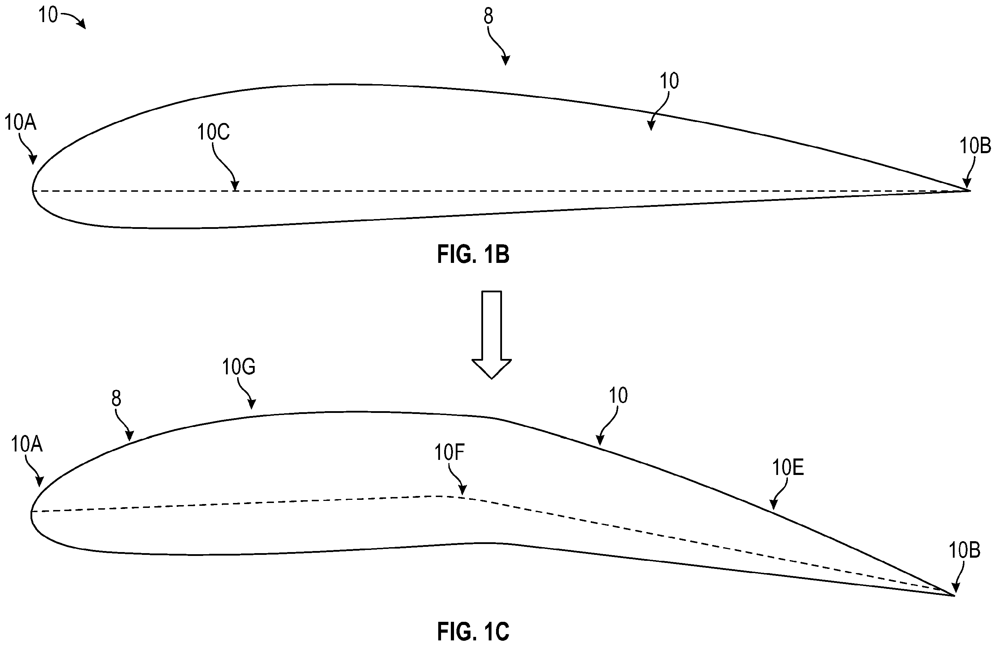

Turning to FIGS. 1B and 1C, an airfoil 8 is disclosed. The airfoil 8 includes a body 10 defining a leading edge 10A and a trailing edge 10B and a cord 10C. A trailing section 10E extends from the trailing edge 10B to an intermediate point 10F, intermediate the leading and trialing edges 10A, 10B. The point 10F may be center cord, quarter cord (from the front), or another location. A leading section 10G extends from the leading edge 10A to the intermediate point 10F. The materials utilized for the airfoil 8 enable predetermined elastic deformation and therefore movement of the trailing section 10E relative to the leading section 10G, e.g., to desirably change camber and therefore lift characteristics for takeoff, during flight and landing. In one embodiment, the airfoil 8 is additively manufactured.

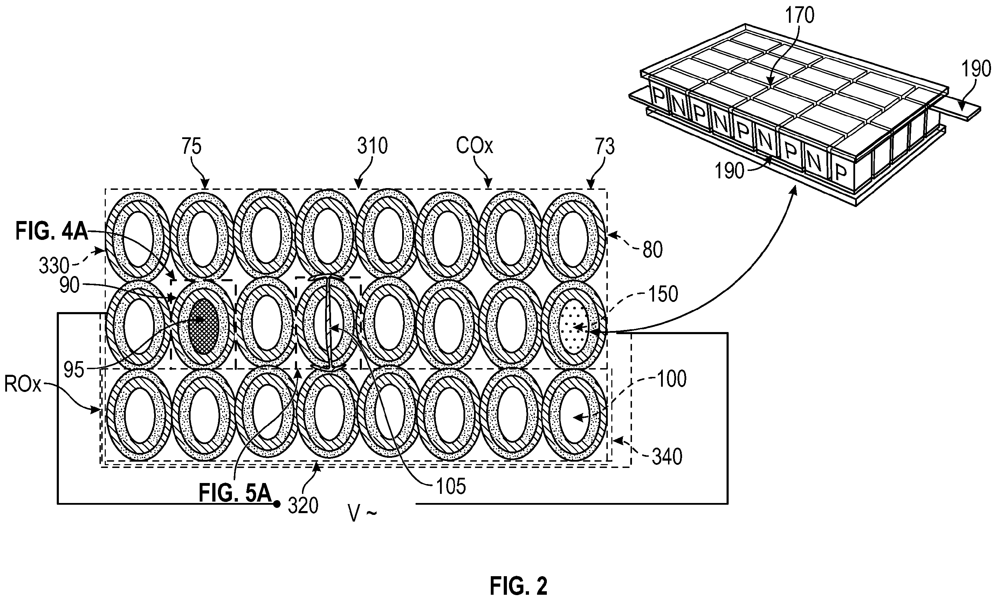

Turning to FIG. 2, the body 10 has a base 70 (or body segment) having an outer boundary 80 extending longitudinally from a first end 310 to a second end 320 and transversely from a first side 330 to a second side 340. Beads 90 are within the outer boundary 80. In FIG. 2, the beads 90 are arranged as a lattice 73 of three rows R0x and nine columns C0x, but this is not intended on limiting the arrangement of the beads 90. The beads 90 may be metal such as a bistable material, or nonmetal, such as thermoplastic. Each of the beads 90 has a bead void 100 so that each bead 90 forms a closed loop.

According to the claims, one or more of the beads 90 includes a damping element (i.e., damping material) 95 within the bead void 100. The damping element 95 may be a thermoplastic. In addition, the one or more of the beads 90 includes a stiffening element (or a stiffening material) 105 extending across the bead 90, over the void 100. The stiffening element 105 may be a reinforcement fiber. The fiber may be a metal fiber, a carbon fiber, or a fiberglass fiber, as nonlimiting examples.

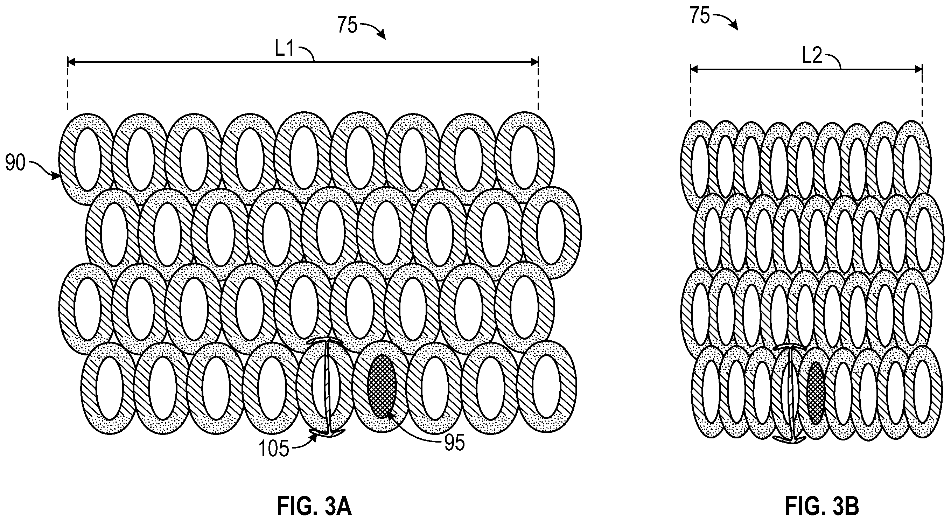

As shown in FIG. 3A, the lattice 73 of beads 90 may have a first length L1 (or longitudinal span) before being subjected to thermal energy. As shown in FIG. 3B, the lattice 73 may have a second length L2 after being subjected to thermal energy, where the second length L2 is less than the first length L1.

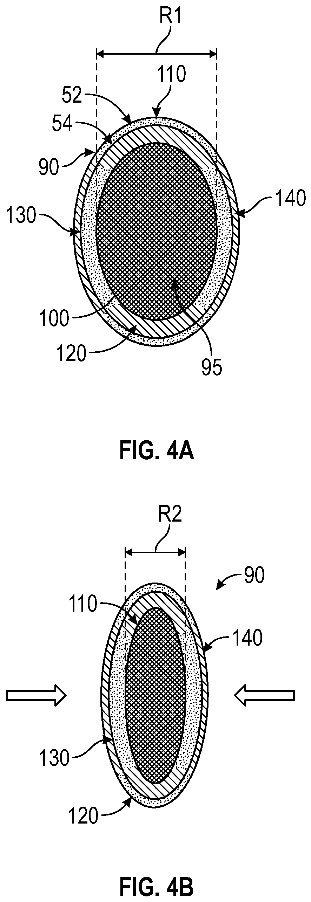

As shown in FIG 4A, in addition to having the damping element 95 in the bead void 100, each of the beads 90 may define first and second perimeter segments 110, 120 that are opposite each other and have a first CTE. Third and fourth perimeter segments 130, 140 may be opposite each other and adjacent to the first and second perimeter segments 110, 120. The third and fourth perimeter segments 130, 140 may have a second CTE that differs from the first CTE, to define a bead CTE gradient. In some embodiments, each of the beads 90 may have an outer surface 52 and an inner surface 54. The inner surface 54 defines the bead void 100. The outer surface 52 of the first and second perimeter segments 110, 120 may have the first CTE. The inner surface 54 of the first and second perimeter segments 110, 120 may have the second CTE. The outer surface 52 of the third and fourth perimeter segments 130, 140 may have the second CTE. The inner surface 54 of the third and fourth perimeter segments 130, 140 may have the first CTE. Thus each segment of the beads 90 may form a segment CTE gradient that is the opposite the adjacent CTE gradient and the same as the opposite bead segment.

As shown in FIG. 4B, the bead 90 may deform to a predetermined shape when subject to thermal energy. For example, the bead 90 may deform from an oval with a first radius R1 along its short axis to an oval with a second radius R2 along the short axis that is smaller than the first radius R1. The damping element 95 may prevent unwanted vibrations during deformation and when the material returns to its normal state (FIG. 4A).

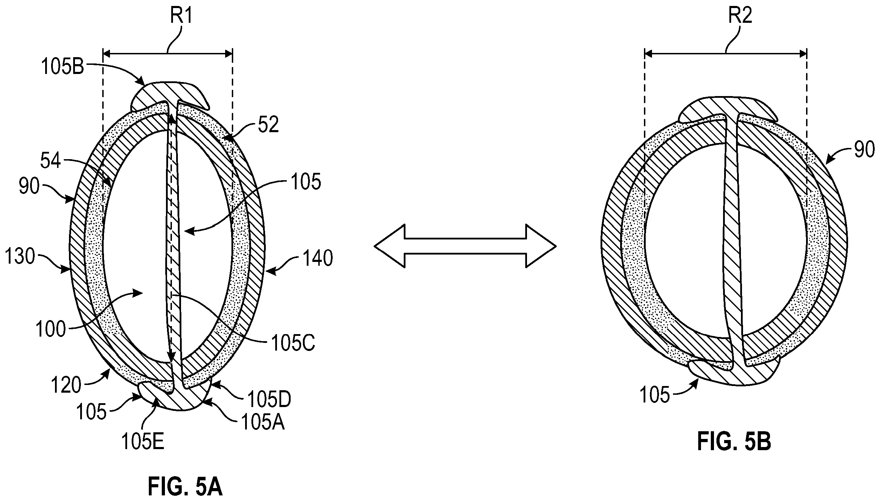

As shown in FIG 5A, in addition to having the stiffening element 105 extending across the bead 90, over the bead void 100, each of the beads 90 may define first and second perimeter segments 110, 120 that are opposite each other and have a first CTE. Third and fourth perimeter segments 130, 140 may be opposite each other and adjacent to the first and second perimeter segments 110, 120. The third and fourth perimeter segments 130, 140 may have a second CTE that differs from the first CTE, to define a bead CTE gradient. In some embodiments, each of the beads 90 may have an outer surface 52 and an inner surface 54. The inner surface 54 defines the bead void 100. The outer surface 52 of the first and second perimeter segments 110, 120 may have the first CTE. The inner surface 54 of the first and second perimeter segments 110, 120 may have the second CTE. The outer surface 52 of the third and fourth perimeter segments 130, 140 may have the second CTE. The inner surface 54 of the third and fourth perimeter segments 130, 140 may have the first CTE. Thus each segment of the beads 90 may form a segment CTE gradient that is the opposite the adjacent CTE gradient and the same as the opposite bead segment.

As indicated, the stiffening element 105 may extend to the outer surface 52 of the first and second segments 110, 120. The stiffening element 105 at each end 105A, 105B may extend circumferentially over a portion of the outer surface 52, in either direction away from an axis 105C extending through the stiffening element 105. Thus each end 105A, 105B has securing tabs 105D, 105E formed by the stiffening element 105 to secure it to the bead 90. However, this is not intended on limiting the configuration of the stiffening element 105.

As shown in FIG. 5B, the bead 90 may deform to a predetermined shape when subject to thermal energy. For example, the bead 90 may deform from an oval with a first radius R1 along its short axis to an oval with a second radius R2 along the short axis that is smaller than the first radius R1. The stiffening element 105, as with the damping element 95, may prevent unwanted vibrations during deformation and when the material returns to its normal state (FIG. 5A).

Turning back to FIG. 2, a thermoelectric junction 150 may be disposed around the outer boundary 80, as illustrated around the second end 320 and portions of the first and second sides 330, 340, as non-limiting embodiments, or in one or more of the bead voids 100. This may enable selectively adding thermal energy to the lattice 73 to obtain the predetermined deformation, such as the actuation of the actuator 10.

The thermoelectric junction 150 may form a Peltier or a Thomson device. For example, alternating P and N-type pillars made with materials with different Seebeck coefficients, or legs, are placed thermally in parallel to each other and electrically in series and joined with a thermally conducting plate on each side, e.g., ceramic, including a cooling plate 160 and a heating plate 170. When a voltage is applied to the free ends of the two semiconductors, via connections 190 there is a flow of DC current across the junction of the semiconductors, causing a temperature difference. The side with the cooling plate 160 absorbs heat which is then transported by the semiconductor to the other side of the device. One of the cooling plate 160 or heating plate 170 may be exposed to the atmosphere if desired to bleed energy from it rather than directing energy from it back to the component 10.

It is within the scope of the embodiments for one or more of beads 90 to includes combinations of the thermoelectric junction 150 within the bead void 100 or around the outer boundary 80, the damping element 95 within the bead void 100, the stiffening element 105 extending across the bead 90.

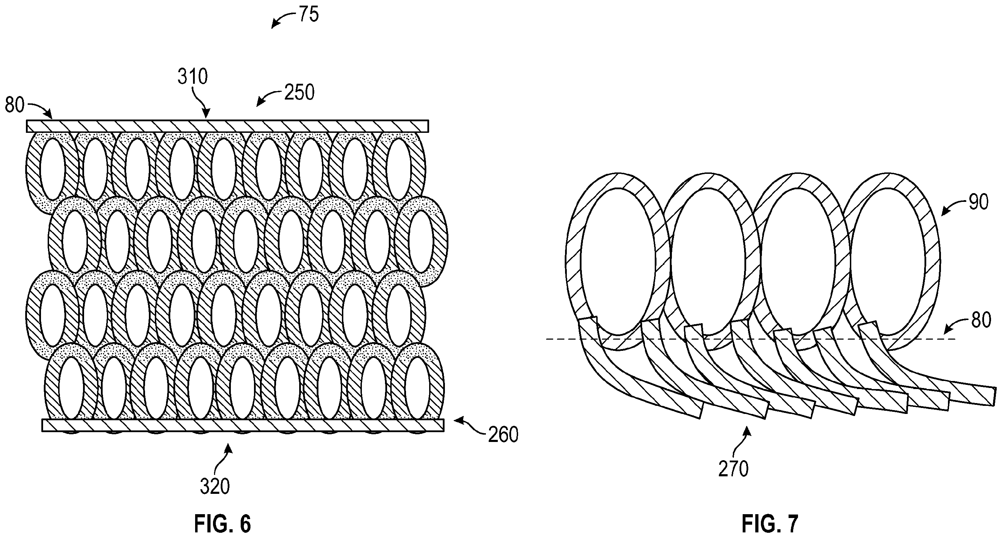

Turning to FIG. 6, the first and second ends 310, 320, along the outer boundary 80 of the base 75 may include a top elastomer layer 250 and a bottom elastomer layer 260. These layers may be utilized for enclosing the beads 90.

Turning to FIG. 7, the base 75 may include an elastomer segment 270 that extends from each of the beads 90 that are located along the outer boundary 80. As a result, adjacent ones of the elastomer segments 270 may overlap each other to define a flexible outer boundary cover.

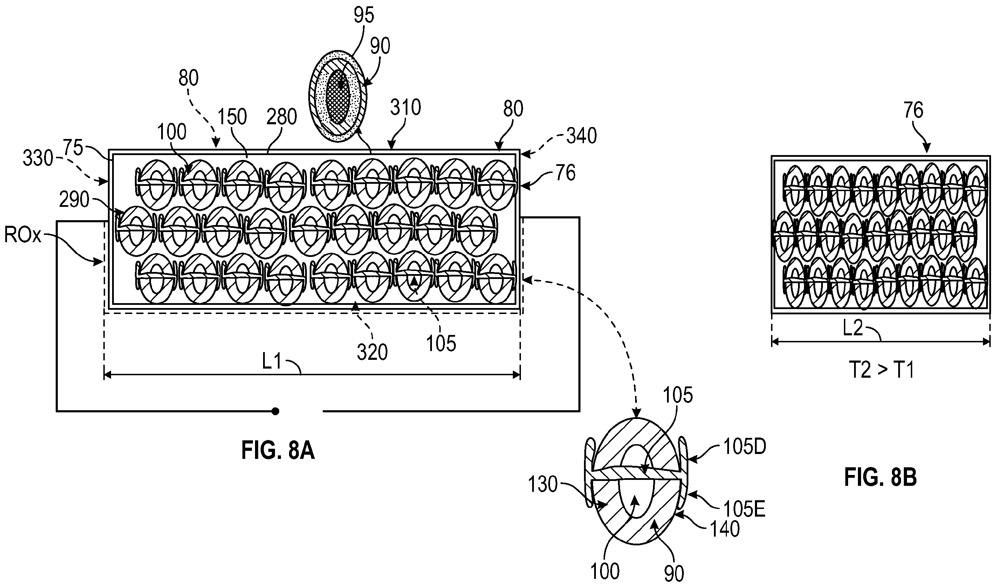

Turning to FIG. 8A, the base 75 may be formed as a block 76 having an outer surface 77 defining the outer boundary 80 having the geometry identified in FIG. 2, including the first and second ends 310, 320 and the first and second sides 330, 340. The block 76 may define base voids 290, distributed in rows ROx, with three rows shown. Adjacent rows ROx are offset from each other, though they may be aligned in an alternative embodiment to form columns of beads 90 (FIG. 2). Each of the base voids 290 may be lined with one of the beads 90. The block 76 may be metal, such as a bistable metal, or nonmetal, such as a thermoplastic.

The thermoelectric junction 150 may be disposed around the outer boundary 80 of the block 75, as illustrated around the second end 320 and portions of the first and second sides 330, 340, as non-limiting embodiments, or in one or more of the bead voids 100. The stiffening element 105 may extend across bead 90 from the outer surface 52 between the third and fourth segments 130, 140 to form the securing tabs 105D, 105E along these segments 130, 140.

As shown in FIG. 8A, a block 75 containing the beads 90 may have a first length L1 (or longitudinal span) before being subjected to thermal energy. As shown in FIG. 8B, the block 75 may have a second length L2 after being subjected to thermal energy, where the second length L2 is less than the first length L1.

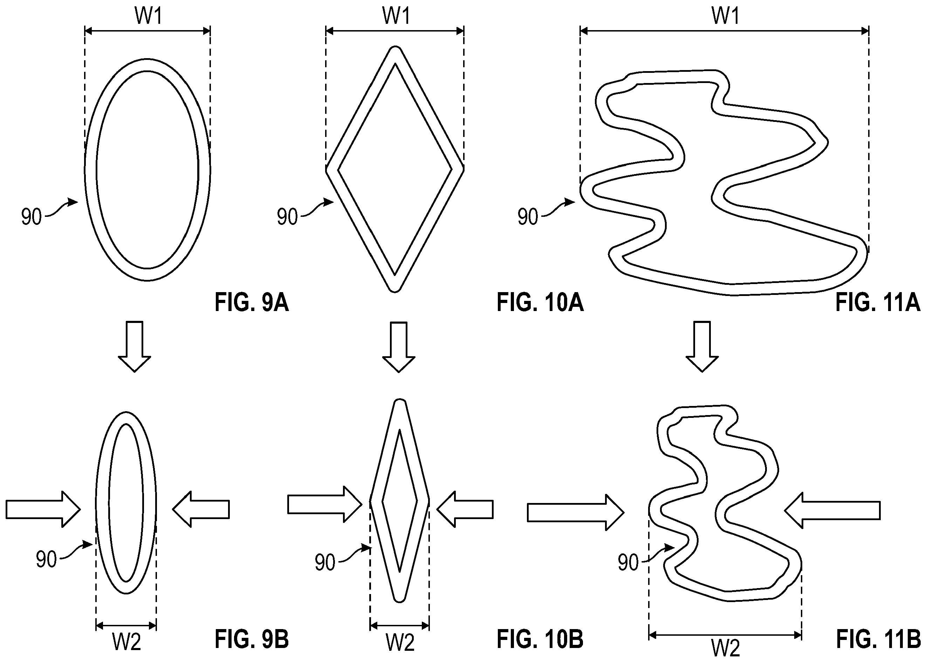

FIG. 9A shows an oval shaped bead 90, which may be formed as indicated above, in a normal state having a first width W1. FIG. 9B shows the oval bead 90 in a deformed state having a second width W2 that is less than the first width W1. As indicated, the beads 90 do not need to be arcuate in shape. FIG. 10A shows a diamond shaped bead 90 in a normal state having a first width W1. FIG. 10B shows the diamond shaped bead 90 in a deformed state having a second width W2 that is less than the first width W1. FIG. 11A shows a random shaped bead 90 in a normal state having a first width W1. FIG. 11B shows the random shaped bead 90 in a deformed state having a second width W2 that is less than the first width W1. The desired deformation shape may determine the shape of the bead 90.

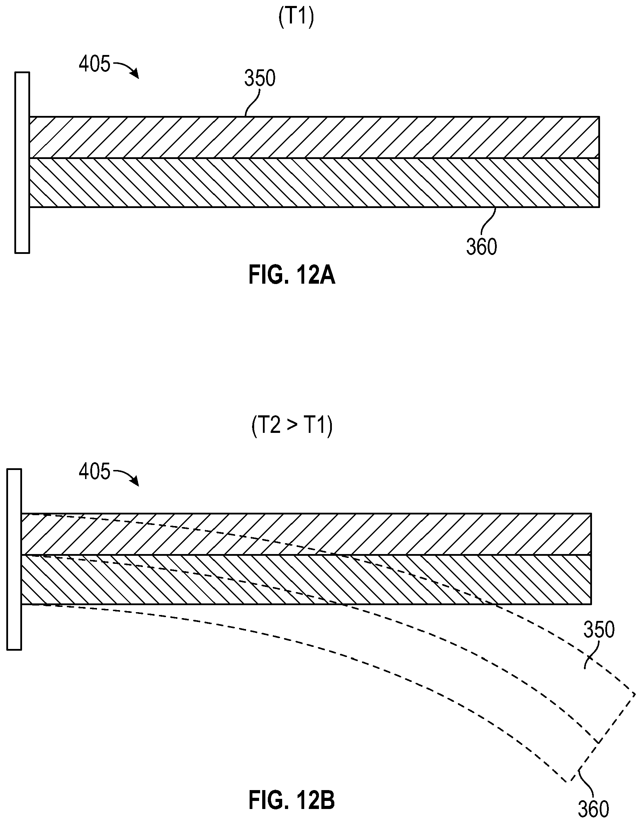

FIGS. 12A and 12B show a linear equivalent structure 405 to the beads 90. Specifically, the first and second segment 350, 360 are at a temperature T1 in FIG. 12A, and T2 that is greater than T1 in FIG. 12B, i.e., they have received thermal input. The controlled thermal expansion shown in FIG. 12B results from the segments being integrally connected. That is, the first and second segments 350, 360 bend together in a predictable and controlled way. That is, the controlled thermal expansion of the first and second segments 350, 360 in the disclose embodiments provides for controlled manipulation of the component disclosed herein.

The terminology used herein is for the purpose of describing particular embodiments only and is not intended to be limiting of the present disclosure. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

Those of skill in the art will appreciate that various example embodiments are shown and described herein, each having certain features in the particular embodiments, but the present disclosure is not thus limited. Rather, the present disclosure can be modified to incorporate any number of variations that fall within the scope of the invention as defined by the claims.

## Claims

1. An airfoil, comprising:
a body (10) defining a leading edge (10A) and a trailing edge (10B), wherein the body comprises:
a base (70) having an outer boundary (80) extending longitudinally from a first end (310) to a second end (320) and transversely from a first side (330) to a second side (340); and
beads (90) within the outer boundary,
wherein each of the beads has a bead void (100), and
wherein one or more of the beads includes:
a damping element (95) within the bead void; and
**characterized in that** one or more of the beads includes:
a stiffening element (105) extending across the bead over the bead void (100).

2. The airfoil of claim 1, wherein:
the damping element (95) is a thermoplastic.

3. The airfoil of any preceding claim, wherein:
the stiffening element (105) is a reinforcement fiber.

4. The airfoil of claim 3, wherein:
the stiffening element one of: a metal fiber; a carbon fiber; and a fiberglass fiber.

5. The airfoil of any preceding claim, wherein:
each of the beads (90) is nonmetal.

6. The airfoil of any preceding claim, wherein:
each of the beads defines:
first and second perimeter segments (110, 120) that are opposite each other and have a first CTE; and
third and fourth perimeter segments (130, 140) that are opposite each other and adjacent to the first and second perimeter segments and have a second CTE that differs from the first CTE, to define a bead CTE gradient.

7. The airfoil of claim 6, wherein:
a thermoelectric junction (150) is disposed around the outer boundary or in one or more of the bead voids.

8. The airfoil of claim 7, wherein:
one or more of the beads includes each of:
the thermoelectric junction (150);
the damping element (95) within the bead void; and
the stiffening element (105) extending across the bead.

9. The airfoil of claim 7 or 8, wherein:
each of the beads defines:
an outer surface (52); and
an inner surface (54), wherein the inner surface defines the bead void, wherein:
the outer surface of the first and second perimeter segments has the first CTE, and the inner surface of the first and second perimeter segments has the second CTE; and
the outer surface of the third and fourth perimeter segments has the second CTE, and the inner surface of the third and fourth perimeter segments has the first CTE.

10. The airfoil of claim 9, wherein:
the outer boundary defines a first outer end and a second outer end, wherein the first and second outer ends are opposite each other, and
the base includes a top elastomer layer (260) that is disposed against the first outer end of the outer boundary and a bottom elastomer layer that is disposed against the second outer end of the outer boundary.

11. The airfoil of claim 9, wherein:
the base includes an elastomer segment that extends from each of the beads that are located along the outer boundary of the base, so that adjacent ones of the elastomer segments overlap each other to define a flexible outer boundary cover.

12. The airfoil of claim 9, wherein:
the base is formed as a block (75) having base voids (290), wherein each of the base voids is lined with one of the beads, and optionally wherein the block is nonmetal.

13. The airfoil of any preceding claim, wherein each of the beads (90) is oval shaped or diamond shaped.

## Patentansprüche

1. Ein Tragfläche, umfassend:
einen Körper (10), der eine Vorderkante (10A) und eine Hinterkante (10B) definiert, wobei
der Körper umfasst:
eine Basis (70) mit einer äußeren Begrenzung (80), die sich in Längsrichtung von einem ersten Ende (310) zu einem zweiten Ende (320) und in Querrichtung von einer ersten Seite (330)
zu einer zweiten Seite (340) erstreckt; und
Wulste (90) innerhalb der äußeren Begrenzung,
wobei jeder der Wulste einen Wulsthohlraum (100) aufweist, und
wobei einer oder mehrere der Wulste Folgendes umfasst:
ein Dämpfungselement (95) innerhalb des Wulsthohlraums, und
ein Versteifungselement (105), das sich über den Wulst über den Wulsthohlraum (100) erstreckt.

2. Die Tragfläche nach Anspruch 1, wobei:
das Dämpfungselement (95) ein Thermoplast ist.

3. Die Tragfläche nach einem der vorhergehenden Ansprüche, wobei:
das Versteifungselement (105) eine Verstärkungsfaser ist.

4. Die Tragfläche nach Anspruch 3, wobei:
das Versteifungselement eines von: einer Metallfaser; einer Kohlenstofffaser und einer Glasfaser ist.

5. Die Tragfläche nach einem der vorhergehenden Ansprüche, wobei:
jeder der Wulste (90) nichtmetallisch ist.

6. Die Tragfläche nach einem der vorhergehenden Ansprüche, wobei:
jeder der Wulste definiert:
erste und zweite Umfangssegmente (110, 120), die einander gegenüberliegen und einen ersten Wärmeausdehnungskoeffizienten (CTE) haben, und
dritte und vierte Umfangssegmente (130, 140), die einander gegenüberliegen und an die ersten und zweiten Umfangssegmente angrenzen und einen zweiten CTE haben, der sich vom ersten CTE unterscheidet, um einen Wulst-CTE-Gradienten zu definieren.

7. Die Tragfläche nach Anspruch 6, wobei:
eine thermoelektrische Verbindung (150) um die äußere Begrenzung oder in einem oder mehreren der Wulsthohlräume angeordnet ist.

8. Die Tragfläche nach Anspruch 7, wobei:
einer oder mehrere der Wulste jeweils Folgendes umfasst:
die thermoelektrische Verbindung (150);
das Dämpfungselement (95) innerhalb des Wulsthohlraums; und
das Versteifungselement (105), das sich über den Wulst erstreckt.

9. Die Tragfläche nach Anspruch 7 oder 8,
wobei:
jeder der Wulste definiert:
eine Außenfläche (52); und
eine Innenfläche (54), wobei die Innenfläche den Wulsthohlraum definiert,
wobei:
die Außenfläche der ersten und zweiten Umfangssegmente den ersten CTE aufweist und die Innenfläche der ersten und zweiten Umfangssegmente den zweiten CTE aufweist; und
die Außenfläche der dritten und vierten Umfangssegmente den zweiten CTE aufweist und die Innenfläche der dritten und vierten Umfangssegmente den ersten CTE aufweist.

10. Die Tragfläche nach Anspruch 9, wobei:
die äußere Begrenzung ein erstes äußeres Ende und ein zweites äußeres Ende definiert, wobei das erste und zweite äußere Ende einander gegenüberliegen, und
die Basis eine obere Elastomerschicht (260) umfasst, die gegen das erste äußere Ende der äußeren Begrenzung angeordnet ist, und eine untere Elastomerschicht, die gegen das zweite äußere Ende der äußeren Begrenzung angeordnet ist.

11. Die Tragfläche nach Anspruch 9, wobei:
die Basis ein Elastomersegment umfasst, das sich von jedem der Wulste erstreckt, die entlang der äußeren Begrenzung der Basis angeordnet sind, so dass benachbarte Elastomersegmente sich überlappen, um eine flexible äußere Begrenzungsabdeckung zu definieren.

12. Die Tragfläche nach Anspruch 9, wobei:
die Basis als ein Block (75) mit Basishohlräumen (290) ausgebildet ist, wobei jeder der Basishohlräume mit einem der Wulste ausgekleidet ist, und optional wobei der Block nichtmetallisch ist.

13. Die Tragfläche nach einem der vorhergehenden Ansprüche, wobei jeder der Wulste (90) oval- oder rautenförmig ist.

## Revendications

1. Une aile, comprenant :
un corps (10) définissant un bord d'attaque (10A) et un bord de fuite (10B), où le corps comprend :
une base (70) ayant une limite extérieure (80) s'étendant longitudinalement d'une première extrémité (310) à une seconde extrémité (320) et transversalement d'un premier côté (330) à un second côté (340) ; et
des perles (90) à l'intérieur de la limite extérieure,
où chacune des perles a un vide de perle (100), et
où une ou plusieurs des perles comprennent :
un élément d'amortissement (95) à l'intérieur du vide de perle, et
un élément de rigidification (105) s'étendant à travers la perle au-dessus du vide de perle (100).

2. L'aile selon la revendication 1, où :
l'élément d'amortissement (95) est un thermoplastique.

3. L'aile selon l'une quelconque des revendications précédentes, où :
l'élément de rigidification (105) est une fibre de renforcement.

4. L'aile selon la revendication 3, où :
l'élément de rigidification est l'un parmi : une fibre métallique ; une fibre de carbone ; et une fibre de fibre de verre.

5. L'aile selon l'une quelconque des revendications précédentes, où :
chacune des perles (90) est non métallique.

6. L'aile selon l'une quelconque des revendications précédentes, où :
chacune des perles définit :
des premier et deuxième segments de périmètre (110, 120) qui sont opposés l'un à l'autre et ont un premier CTE ; et
des troisième et quatrième segments de périmètre (130, 140) qui sont opposés l'un à l'autre et adjacents aux premier et deuxième segments de périmètre et ont un deuxième CTE qui diffère du premier CTE, pour définir un gradient de CTE de perle.

7. L'aile selon la revendication 6, où :
une jonction thermoélectrique (150) est disposée autour de la limite extérieure ou dans un ou plusieurs des vides de perle.

8. L'aile selon la revendication 7, où :
une ou plusieurs des perles comprennent chacune :
la jonction thermoélectrique (150) ;
l'élément d'amortissement (95) à l'intérieur du vide de perle ; et
l'élément de rigidification (105) s'étendant à travers la perle.

9. L'aile selon la revendication 7 ou 8,
où :
chacune des perles définit :
une surface extérieure (52) ; et
une surface intérieure (54), où la surface intérieure définit le vide de perle,
où :
la surface extérieure des premier et deuxième segments de périmètre a le premier CTE, et la surface intérieure des premier et deuxième segments de périmètre a le deuxième CTE ; et
la surface extérieure des troisième et quatrième segments de périmètre a le deuxième CTE, et la surface intérieure des troisième et quatrième segments de périmètre a le premier CTE.

10. L'aile selon la revendication 9, où :
la limite extérieure définit une première extrémité extérieure et une seconde extrémité extérieure, où les première et seconde extrémités extérieures sont opposées l'une à l'autre, et
la base comprend une couche supérieure d'élastomère (260) qui est disposée contre la première extrémité extérieure de la limite extérieure et une couche inférieure d'élastomère qui est disposée contre la seconde extrémité extérieure de la limite extérieure.

11. L'aile selon la revendication 9, où :
la base comprend un segment d'élastomère qui s'étend de chacune des perles qui sont situées le long de la limite extérieure de la base, de sorte que des segments adjacents d'élastomère se chevauchent pour définir une couverture de limite extérieure flexible.

12. L'aile selon la revendication 9, où :
la base est formée comme un bloc (75) ayant des vides de base (290), où chacun des vides de base est tapissé d'une des perles, et éventuellement où le bloc est non métallique.

13. L'aile selon l'une quelconque des revendications précédentes, où chacune des perles (90) est de forme ovale ou en forme de diamant.
